# EUROPÄISCHE PATENTSCHRIFT

(11) **EP 2 515 139 B1**
(45) Veröffentlichungstag und Bekanntmachung des Hinweises auf die Patenterteilung: **17.06.2020**
(21) Anmeldenummer: 12163688.0
(22) Anmeldetag: 11.04.2012
(51) Int. Cl.: G01R 33/567, G01R 33/565

(54) **Verfahren zur quasi-kontinuierlichen dynamischen Bewegungskorrektur bei Messungen der Magnetresonanz**
Method for quasi-continuous dynamic motion correction when measuring magnetic resonance
Procédé de correction dynamique quasi-continue du mouvement pour les mesures de la résonance magnétique

(30) Priorität: 18.04.2011 DE 102011007574
(43) Veröffentlichungstag der Anmeldung: 24.10.2012
(73) Patentinhaber: Universitätsklinikum Freiburg, 79106 Freiburg (DE)
(72) Erfinder: Herbst, Michael, 79104 Freiburg (DE); Zaitsev, Maxim, 79117 Freiburg (DE); MacLaren, Julian, 79100 Freiburg (DE); Weigel, Matthias, 79104 Freiburg (DE)
(74) Vertreter: Kohler Schmid Möbus Patentanwälte

(56) Entgegenhaltungen:
- US-A1- 2009 209 846
- MICHAEL HERBST ET AL: "Prospective motion correction with continuous gradient updates in diffusion weighted imaging", MAGNETIC RESONANCE IN MEDICINE, Bd. 67, Nr. 2, 9. Dezember 2011 (2011-12-09), Seiten 326-338, XP55027336, ISSN: 0740-3194, DOI: 10.1002/mrm.23230
- ORCHARD J ET AL: "MRI reconstruction using real-time motion tracking: A simulation study", SIGNALS, SYSTEMS AND COMPUTERS, 2008 42ND ASILOMAR CONFERENCE ON, IEEE, PISCATAWAY, NJ, USA, 26. Oktober 2008 (2008-10-26), Seiten 1910-1914, XP031475637, ISBN: 978-1-4244-2940-0
- NEHRKE K ET AL: "Prospective correction of affine motion for arbitrary MR sequences on clinical scanners", MAGNETIC RESONANCE IN MEDICINE, ACADEMIC PRESS, DULUTH, MN, US, Bd. 54, Nr. 5, 1. November 2005 (2005-11-01), Seiten 1130-1138, XP002562508, ISSN: 0740-3194, DOI: 10.1002/MRM.20686 [gefunden am 2005-09-30]
- OOI M B ET AL: "Prospective real-time correction for arbitrary head motion using active markers", MAGNETIC RESONANCE IN MEDICINE, ACADEMIC PRESS, DULUTH, MN, US, Bd. 62, Nr. 4, 1. Oktober 2009 (2009-10-01), Seiten 943-954, XP002602077, ISSN: 0740-3194, DOI: 10.1002/MRM.22082 [gefunden am 2009-06-01]
- DOLD ET AL: "Advantages and Limitations of Prospective Head Motion Compensation for MRI Using an Optical Motion Tracking Device", ACADEMIC RADIOLOGY, RESTON, VA, US, Bd. 13, Nr. 9, 1. September 2006 (2006-09-01), Seiten 1093-1103, XP005621999, ISSN: 1076-6332, DOI: 10.1016/J.ACRA.2006.05.010
- MURAT AKSOY ET AL: "Real-time optical motion correction for diffusion tensor imaging", MAGNETIC RESONANCE IN MEDICINE, Bd. 66, Nr. 2, 22. März 2011 (2011-03-22), Seiten 366-378, XP55031759, ISSN: 0740-3194, DOI: 10.1002/mrm.22787
- P. HU ET AL: "MOtion Correction using Coil Arrays (MOCCA)", PROC.INTL.SOC.MAG.RESON.MED., 1. Januar 2010 (2010-01-01), Seite 3058, XP55031761,

## Beschreibung

Die Erfindung betrifft ein Verfahren der MR-Bildgebung oder der ortsaufgelösten MR-Spektroskopie zur Reduzierung durch Bewegung eines darzustellenden Objektes auftretender Artefakte, wobei eine MR-Aufnahme des darzustellenden Objekts mit einem MR-Tomographen erfolgt, indem eine MR-Sequenz ausgeführt wird, in deren Repetitionszeit-Intervall ein oder mehrere HF-Pulse und mehrere Magnetfeldgradientenpulse eingestrahlt werden, wobei das Repetitionszeit-Intervall eine MR-Signalgewichtungsperiode und eine MR-Signalausleseperiode - im Folgenden jeweils mit dem Begriff "Teilakquisitionen (TA)" bezeichnetumfasst, wobei die aktuelle Position des darzustellenden Objekts während der Laufzeit der MR-Aufnahme quasi-kontinuierlich bestimmt wird, wobei eine prospektive Bewegungskorrektur während der Laufzeit der MR-Aufnahme vorgenommen wird, welche eine dynamische Anpassung der Frequenz- und Phaseneinstellungen des HF-Systems des MR-Tomographen und der Orientierung und der Amplituden der Gradientenpulse in der Art umfasst, dass das darzustellende Volumen an die aktuelle Position des darzustellenden Objekts angepasst wird.

Ein solches Verfahren ist bekannt aus
DOLD ET AL: "Advantages and Limitations of Prospective Head Motion Compensation for MIRE Using an Optical Motion Trecking Device", ACADEMIC RADIOLOGY, RESTON, VA, US, Bd. 13, Nr. 9, 1. September 2006 (2006-09-01), Seiten 1093-1103, XP005621999, ISSN: 1076-6332, D01: 10.1016/J.AC RA.2006.05.010.

MR-Tomographie, auch als bildgebende Magnetresonanz (=MRI), MR-Bildgebung oder Magnetresonanztomographie (=MRT) bezeichnet, ist ein nichtinvasives Verfahren, welches es ermöglicht, die innere Struktur von Objekten räumlich dreidimensional aufzulösen und darzustellen. Sie basiert auf dem energetischen Verhalten von Atomkernen in einem Magnetfeld, welches eine Anregung ihrer Kernspins durch geeignete Hochfrequenzpulse und eine anschließende Analyse der Reaktion erlaubt. Anwendung findet die bildgebende MRT vor allem in der Medizin, um Einblicke in das Innere eines menschlichen Körpers zu erhalten.

Das als Reaktion auf die Anregung mit Hochfrequenzpulsen ausgesendete Signal der Atomkerne des zu untersuchenden Objektes wird mit geeigneten Empfangsspulen ausgelesen. Die notwendige Ortskodierung, um das Messsignal einem Ort innerhalb des abzubildenden Objektes zuordnen zu können, erfolgt über zusätzliche, räumlich veränderliche, Magnetfelder B_{z}(x,y,z), welche dem statischen Hauptmagnetfeld B₀ überlagert werden und somit bewirken, dass Atomkerne an unterschiedlichen Orten unterschiedliche Larmorfrequenzen aufweisen. Konventionell werden hier Magnetfelder mit einer möglichst linearen Änderung der Stärke entlang der jeweiligen Raumrichtung verwendet, sogenannte konstante, beziehungsweise lineare Magnetfeldgradienten. Übliche Gradientensystem erzeugen hierbei drei orthogonale Gradienten in x-, y- und z-Richtung, jedoch finden auch lokale Gradientensysteme in der Ortskodierung Verwendung. Die 1-, 2- oder 3-dimensionale Ortskodierung erfolgt unter Variation der Magnetfeldgradienten in allen drei Raumrichtungen entsprechend den bekannten Prinzipien, etwa der Fourierkodierung, der gefilterten Rückprojektion oder einem anderen bekannten Verfahren (siehe Referenz [11]).

Zur Erzeugung eines für die MR verwendbaren Signals werden einem stationären Magnetfeld räumlich veränderliche Magnetfelder sowie HF-Pulse überlagert. Eine fehlerfreie, insbesondere artefaktfreie Abbildung ist nur bei vollständiger Unbeweglichkeit des darzustellenden Messobjektes während des gesamten darstellenden Prozesses zu erreichen.

Bildartefakte und Signalstörungen, die durch Bewegung während des darstellenden Prozesses auftreten, limitieren die zu erreichende Bildqualität. Im klinischen Alltag kann Patientenbewegung zur Unbrauchbarkeit von Aufnahmen führen, die zu Zeitverlust aufgrund von Aufnahmewiederholungen oder gar zu Fehldiagnosen führen.

Die Möglichkeit auftretende Bewegung zu erkennen und zu korrigieren ist daher ein wesentlicher Faktor die Qualität der mittels MR gewonnenen Daten zu garantieren. Insbesondere im klinischen Alltag lässt sich durch die Vermeidung von Bewegungsartefakten die Effizienz des Messablaufs steigern und die Kosten erheblich reduzieren. Ein solches Verfahren zur Echtzeit-Bewegungskorrektur während der MR-Aufnahme ist aus der unten aufgeführten Referenz [1] bekannt.

Zur Vermeidung von Bewegungsartefakten in MR-Aufnahmen sind drei grundlegende Ansätze bekannt:
1.) Beim sogenannten Gating wird die Aufnahme unterbrochen, sobald sich das Messobjekt nicht mehr in einer gewünschten Position befindet, und fortgesetzt, sobald die entsprechende Position wieder eingenommen wird. Ein Gating der Atembewegung wird besonders bei Aufnahmen des Bauch- und Brustbereichs von Patienten häufig genutzt. Diese Methode hat den Nachteil, dass sich die Dauer für eine MR-Aufnahme beträchtlich erhöht.[2]
2.) Bei der retrospektiven Korrektur wird die MR-Aufnahme auch bei auftretender Objektbewegung unverändert durchgeführt, sie verändert daher nicht den zeitlichen Ablauf der Aufnahme. Allerdings ist eine retrospektive Korrektur nur bei einer begrenzten Anzahl von Bildartefakten möglich. Bei Bewegungen, die zu inkonsistenten Bildobjekten oder Signalverlust führen, scheitern retrospektive Methoden. [3]
3.) Die prospektive Bewegungskorrektur ermöglicht die Reduzierung der durch Patientenbewegung auftretende Artefakte mit Hilfe der Anpassung des darzustellenden Volumens an die aktuelle Position des Messobjektes. Dafür wird die Position des darzustellenden Messobjektes während der gesamten MR-Aufnahme von einem Messsystem bzw. Messverfahren erfasst. Wird nun eine Bewegung des Messobjekts beobachtet, dann werden in Echtzeit dynamische Anpassungen der Frequenz- und Phaseneinstellungen des Hochfrequenzsystems (HF-Systems) des Tomographen und der Orientierung und der Amplituden der Gradienten vorgenommen.

Ein mögliches Messverfahren ermittelt Positionsdaten mit Hilfe von MR-Navigatorsequenzen. Diese Navigatorsequenzen erfordern eine kurze Unterbrechung im Sequenzablauf und sind daher nur für bestimmte Aufnahmen einsetzbar und ermöglichen nur wenige Korrekturen pro Sekunde. [4, 5] Ein vielversprechender Ansatz beinhaltet die Installation eines (z.B. optischen) Messsystems innerhalb oder außerhalb des Tomographen. Damit ist es möglich Informationen über die Objektposition parallel zur MR-Aufnahme zu erhalten. [1, 6-8]

Im Allgemeinen besteht eine Aufnahme mittels MR-Tomographie aus einzelnen Teilprozessen aus Signalerzeugung und/oder -erfassung mit einer typischen Dauer > 4ms. Vor Beginn einer solchen Teilakquisition werden alle für die Teilakquisition benötigten Parameter (Gradienten, HF-Pulse, Trägerfrequenzen und -phasen) berechnet.

Zwei grundlegende Ansätze zur prospektiven Bewegungskorrektur werden beschrieben:
1.) Bei einer Korrektur mittels Softwareinterface wird die Berechnung einzelner Teilakquisitionen an die veränderte Position des Messobjektes angepasst und die jeweiligen Parameter entsprechend dieser Position berechnet. Die berechneten Sequenzparameter werden anschließend digital an einen Signalgenerator gesendet.[1, 6-10]
2.) Bei der Bewegungskorrektur mittels Hardwareinterface werden diese digitalen Signale einer berechneten Teilakquisitionen an die veränderte Position des Messobjektes angepasst. Während kurzer Ruhephasen (< 2ms) zwischen den einzelnen Teilakquisitionen wird eine Anpassung der digitalen Signale der darauffolgenden Teilakquisition an eine veränderte Objektposition vorgenommen.[1, 9]

In [6] wird eine Methode zur Bewegungskorrektur für beliebige Aufnahmen beschrieben. Dabei wird vor der Schichtanregung eine Anpassung an die Objektposition vorgenommen. Zusätzlich wird optional nach der Signalausleseperiode eine weitere Bestimmung der Objektposition und bei Überschreiten von Bewegungslimits eine Wiederholung der betroffenen Teilakquisitionen durchgeführt. Bewegungen während des zeitlichen Verlaufs der einzelnen Teilakquisitionen werden nicht korrigiert.

In [7] wird ein Aufbau eines Systems zur Bewegungskorrektur beschrieben. Die Bewegungskorrektur wird dabei für zu Beginn jeder Teilakquisition durchgeführt. Eine Bewegungskorrektur während des zeitlichen Verlaufs der einzelnen Teilakquisitionen wird nicht beschrieben.

In [1] wird eine Methode zu Bewegungskorrektur für beliebige Aufnahmen beschrieben. Für die eigentliche Anwendung der Bewegungskorrektur werden zwei Möglichkeiten (mittels Softwareinterface und mittels Hardwareinterface) vorgeschlagen. Bei der ersten Ausführung mittels Softwareinterface erfolgt jeweils eine Bewegungskorrektur zu Beginn jeder sequenzspezifischen Teilakquisition. Eine Bewegungskorrektur während des zeitlichen Verlaufs der einzelnen Teilakquisitionen (insbesondere die unterbrechungsfreie Bewegungskorrektur von andauernden Gradienten) wird nicht beschrieben. Bei der zweiten Ausführung mittels Hardwareinterface wird die Bewegungskorrektur in kurzen Ruheperioden zwischen 2 Teilakquisitionen durchgeführt. Eine Bewegungskorrektur während des zeitlichen Verlaufs der einzelnen Teilakquisitionen wird ebenfalls nicht beschrieben.

In [8] wird ein Aufbau eines Systems zur Bewegungskorrektur beschrieben. Dabei wird zwar zu Beginn jeder Teilakquisition jeweils eine Bewegungskorrektur durchgeführt, nicht jedoch während des zeitlichen Verlaufs der einzelnen Teilakquisitionen.

In [10] wird eine Methode zur Bewegungskorrektur unter Verwendung des in [7] beschriebenen Verfahrens vorgestellt. Dabei wird lediglich vor jeder Schichtanregung eine Anpassung der Objektposition vorgenommen.

In [9] wird eine Methode zur Bewegungskorrektur während einer Aufnahme zur diffusionsgewichteten Bildgebung (DWI) unter Verwendung des in [1] beschriebenen Verfahrens vorgestellt. Dafür werden Bewegungskorrekturen vor jeder Schichtanregung und vor jeder Signalausleseperiode angewendet. Bewegungen die zwischen Schichtanregung und Signalausleseperiode auftreten werden lediglich detektiert und die betroffenen Teilakquisitionen werden verworfen und wiederholt.

In [5] wird eine Methode beschrieben, die eine bei der DWI während der Diffusionsgewichtung auftretende Objektrotation durch eine Kombination aus Navigatorsequenzen und zusätzlich ausgespielte Korrekturgradienten kompensiert. Mit dieser Korrekturvariante werden lediglich Artefakte durch Rotationen des Messobjekts während der angewandten Gradienten korrigiert. Diese Korrektur erfordert außerdem eine Unterbrechung der Aufnahme für das Ausspielen der Navigatorsequenz und zum Ausspielen der Korrekturgradienten.

Bewegung, die während des zeitlichen Verlaufs einer Teilakquisition (je nach Aufnahmemethode im Bereich von 4-1000ms) auftritt, kann zu schwerwiegenden Artefakten und Signalverlust führen. Keine der bisher vorgestellten Methoden beschreibt eine Möglichkeit diese zu korrigieren - lediglich eine Wiederholung der betroffenen Teilakquisition(en) kann vorgenommen werden, verlängert aber die Dauer der MR-Aufnahme entsprechend.

ORCHARD J ET AL: "MRI reconstruction using real-time motion tracking: A simulation study", SIGNALS, SYSTEMS AND COMPUTERS, 2008, 42ND ASILOMAR CONFERENCE ON IEEE, PISCATAWAY, 26. Oktober 2008 (2008-10-26), Seiten 1910-1914, XP031475637, ISBN: 978-1-4244-2940-0
beschreibt die Simulation von Bewegungsartefakten und die Theorie einer Rotation der Gradienten in Echtzeit mit einer zusätzlichen Phasenkorrektur der Messdaten (siehe: Methods C, Motion Correction: ,applying the phase correction term... to each sample'). Eine dynamische Anpassung der Frequenz- und Phaseneinstellungen des HF-Systems wird nicht beschrieben. Die technische Ausführung einer kontinuierlichen Rotation der Gradienten wird ebenfalls nicht beschrieben.

OOI M B ET AL: "Prospective real-time correction for arbitrary head motion using active markers", MAGNETIC RESONANCE IN MEDICINE, ACADEMIC PRESS, DULUTH, MN, US, Bd. 62, Nr. 4, 1. Oktober 2009 (2009-10-01), Seiten 943-954, XP002602077, ISSN: 0740-3194, D01: 10.1002/MR M.22082 beschreibt eine Methode zur prospektiven Bewegungskorrektur einer MR-Sequenz. Dabei wird vor der Schichtanregung eine Anpassung an die Objektposition vorgenommen (siehe: Introduction, letzter Abschnitt: ,between single or multiple lines of k-space'). Zusätzlich wird für spezielle Sequenzen eine optionale Korrektur der Bewegungen innerhalb der Echozeit vorgeschlagen (siehe: Discussion, letzter Abschnitt: for ASL, ,incorporated into the transit time'; ,for spectroscopy, between sampling of averages'). Eine Korrektur während der Signalgewichtungsperiode oder eine Korrektur während der Signalausleseperiode wird nicht beschrieben.

In der eingangs zitierten Publikation von DOLD ET AL schließlich wird wiederum eine Methode zur prospektiven Bewegungskorrektur einer MR-Sequenz beschrieben. Dabei wird vor der Schichtanregung eine Anpassung an die Objektposition vorgenommen. Zusätzlich wird optional eine Korrektur der Bewegungen innerhalb der Echozeit vorgeschlagen (siehe Discussion, Abschnitt 3: Doing movement correction within TE and TR appears to be possible'). Eine Korrektur während der Signalgewichtungsperiode oder eine Korrektur während der Signalausleseperiode wird nicht beschrieben.

### Aufgabe der Erfindung

Der vorliegenden Erfindung liegt demgegenüber die Aufgabe zugrunde, bei einem Verfahren der MR-Bildgebung oder -Spektroskopie der eingangs beschriebenen Art die Artefakte aufgrund von Bewegungen des darzustellenden Objektes noch weiter zu reduzieren.

### Kurze Beschreibung der Erfindung

Diese Aufgabe wird erfindungsgemäß auf ebenso überraschend einfache wie wirkungsvolle Weise dadurch gelöst, dass die MR-Signalgewichtungsperiode in mehrere Teilakquisitionspartitionen aufgeteilt wird und Gradientenpulse der MR-Signalgewichtungsperiode in kürzere Teilgradienten derart aufgeteilt werden, dass jeder Teilgradient nur während einer einzigen Teilakquisitionspartition eingeschaltet wird,
und dass die prospektive Bewegungskorrektur für jede der Teilakquisitionspartitionen der MR-Signalgewichtungsperiode erfolgt, wobei die dynamische Anpassung der Frequenz- und Phaseneinstellungen des HF-Systems des MR-Tomographen und der Orientierung und der Amplituden der Gradientenpulse für die jeweilige Teilakquisitionspartition unter Einbezug der aktuellen Position des darzustellenden Objekts erfolgt.

Die Bewegungskorrektur erfolgt dabei mehrmals (und im Idealfall quasi-kontinuierlich, d.h. in Zeitabständen < 3ms, je nach Verfügbarkeit der Objektpositionsdaten) während einer Teilakquisition, im Gegensatz zu bekannten, für die Bewegungskorrektur eingesetzten Verfahren, die keine dynamische Anpassung innerhalb einer Teilakquisition erlauben. Dynamische Korrektur versteht sich so, dass während des zeitlichen Verlaufs wenigstens der Signalgewichtungsperiode, und bevorzugt während der zwei genannten Perioden (Signalgewichtungs- und Signalausleseperiode) die Bewegungskorrektur mit aktualisierten Parametern erfolgen soll. Dabei ist hervorzuheben, dass lediglich durch solch eine mehrmalige Anpassung während einzelner Teilakquisitionen wichtige Kriterien der MR-Bildgebung und - Spektroskopie eingehalten werden können:
1.) Das Timing der MR-Aufnahme bei quasi-kontinuieriicher Bewegungskorrektur soll eingehalten werden (keine Zeitbeanspruchung für die Bewegungskorrektur).
   Ein Problem vieler bereits beschriebener Methoden ist, dass der zeitliche Ablauf der MR-Aufnahme für die Bewegungskorrektur angepasst werden muss. Falls die benötigte Unterbrechung im Signalverlauf der Sequenz nicht gegeben ist, oder geschaffen werden kann, ist keine Bewegungskorrektur möglich. Das erfindungsgemäße Verfahren ermöglicht die Bewegungskorrektur ohne Veränderungen des zeitlichen Ablaufs der MR-Aufnahme, indem benötigte Parameter parallel zur MR-Aufnahme bestimmt und/ oder berechnet werden, wobei der Zeitbedarf für entsprechende Bestimmungen/ Berechnungen mit einbezogen wird.
2.) Für MR-Aufnahmen ist es wichtig einen definierten effektiven Gradienten relativ zum Messobjekt anzuwenden. Es ist essentiell, dass die effektive Gradientenfläche - auch als nulltes Moment oder Gradientenmoment bezeichnet - pro Kodierungsachse (Gx, Gy und Gz) vor der Signalausleseperiode genau den Voraussetzungen entspricht. Diese Kondition wird durch Objektbewegung, insbesondere Rotationen, gestört. Das vorgestellte erfindungsgemäße Verfahren korrigiert dies, indem es bei Bewegungen die Gradienten quasi-kontinuierlich korrigiert und so direkt im eigentlichen, gemessenen Objekt diese notwendige Phasenentwicklung erreicht, was die gewünschte Signalevolution gewährleistet.
3) Weiterhin essentiell ist, dass die ursprünglich gesetzten Phasenbeziehungen der HF-Pulse - die sog. anfänglichen Phasen - erhalten bleiben. Dies ist besonders für Multi-Puls-Sequenzen wichtig (z.B. Echozug-Sequenzen wie RARE). Bei Auftreten der Bewegung des Objektes kann diese Kondition gestört werden. Das vorgestellte Verfahren ermöglicht die Phasenstabilität wiederherzustellen, indem es ebenfalls die Trägerfrequenzen und Phasen der HF-Pulse gemäß der Bewegungskorrektur anpasst, so dass im gemessenen Objekt die vorgesehenen, anfänglichen Phasen der HF-Pulse erhalten bleiben. Dabei können auch die Restfehler in vorhergehenden
   Refokussierungsintervallen berücksichtigt werden.

### Bevorzugte Ausführungsformen der Erfindung

Erfindungsgemäss werden somit lang andauernde Gradienten, welche sich zeitlich über die Grenze zweier aufeinander folgender Teilakquisitionspartitionen erstrecken, in kürzere Teilgradienten derart aufgeteilt, dass jeder Teilgradient nur während einer einzigen Teilakquisitionspartition geschaltet wird. Dabei erfolgt die abschließende Berechnung aller für die jeweilige Teilakquisitionspartition benötigter Parameter sequenziell und jeweils unter Einbezug aktueller Positionsdaten. Es ist zu beachten, dass die Erfindung somit auch vorsieht, längere Gradienten, die Grenzen von einem oder mehreren Teilakquisitionspartitionen überschreiten, in zwei oder mehr Teilgradienten aufzuteilen. Die Aufteilung einer Teilakquisition in mehrere Teilakquisitionspartitionen bietet den Vorteil, die Bewegungskorrektur während einer Teilakquisition verwirklichen zu können und unter anderem die bewegungsinduzierten Effekte während der Anwendung von langen Gradientenpulsen zu kompensieren. Die zeitveränderlichen Gradienten, die bei starken Bewegungen generiert werden können, werden unter der Berücksichtigung der Hardwarespezifikationen zwischen den Teilgradienten entsprechend interpoliert.

Bei einer bevorzugten Variante dieser Erfindung werden Korrekturabweichungen in vorherigen Teilakquisitionspartitionen während der laufenden Teilakquisition oder Teilakquisitionspartition detektiert und mittels zusätzlicher Gradientenmomente oder Phasenänderungen vor der Signalausleseperiode oder dem nächsten HF-Puls korrigiert. Dabei werden zusätzlich zur aktuellen Objektposition der Bewegungsverlauf und die bisher angewendeten Korrekturmaßnahmen analysiert. Diese Weiterentwicklung bietet den Vorteil, dass Abweichungen zwischen tatsächlichem Bewegungsverlauf und angewendeter Korrektur erkannt und somit entstandene Korrekturabweichungen der vorherigen Teilakquisitionspartitionen während der laufenden Teilakquisition bzw. Teilakquisitionspartition detektiert werden. Mittels zusätzlicher Gradientenmomente bzw. Phasenänderungen vor der Signalausleseperiode bzw. dem nächsten HF-Puls können diese Korrekturabweichungen effizient kompensiert werden. Insbesondere, wenn solche Korrekturmaßnahmen vor Ende jedes Refokussierungsintervalls (wie etwa in Echozug-Sequenzen) eingesetzt werden, erlaubt dies die Störungen des Spinmagnetisierungszustandes zu reduzieren.

Besonders bevorzugt ist eine Variante des obigen Verfahrens, welche sich dadurch auszeichnet, dass die zusätzlichen Gradientenmomente zur Abweichungskorrektur bereits vorhandenen Gradienten überlagert werden. Diese Variante bietet den Vorteil, dass der zeitliche Verlauf und die Anzahl der verwendeten Gradientenpulsen der laufenden Aufnahme erhalten bleibt, wodurch sich weitere störende Effekte wie etwa die durch Gradientenschaltung induzierten Wirbelströme minimieren lassen.

Eine unter realistischen Bedingungen sehr wichtige Ausführungsform der Erfindung ist dadurch gekennzeichnet, dass bei Überschreitung von Bewegungsamplituden- oder Geschwindigkeitslimits eine oder mehrere Teilakquisitionen verworfen und wiederholt werden. Um die entsprechenden Phasen zu identifizieren, werden die Kriterien vor Beginn der Messung festgelegt, die entweder feste Schwellwerte für maximal akzeptable Objektverschiebungen bzw. -rotationen, für maximale Bewegung während einer Teilakquisition oder für maximale lineare bzw. Winkel-Geschwindigkeiten vorschreiben.

Alternativ können solche Schwellwerte automatisch aus der Analyse von aufgenommenen Bewegungsparametern unter Einbeziehung von MR-Sequenzparametern berechnet werden. Diese Variante bietet den Vorteil, dass ein Überschreiten von für die Bewegungskorrektur einzuhaltender Grenzen während einzelner Teilakquisitionen nicht zur Verfälschung des Ergebnisses der MR-Aufnahme führt. Damit wird verhindert, dass die gesamte Aufnahme verworfen und unter Umständen wiederholt werden muss, und nur einzelne Teilakquisitionen während der laufenden MR-Aufnahme wiederholt werden, was lediglich zu moderater Verlängerung der MR-Aufnahme führt. Ein besonderes Merkmal dieser Ausführungsform im Vergleich zum Stand der Technik ist, dass auch schnelle Bewegungen innerhalb einer Teilakquisition, bei denen das Messobjekt vor Ende der Teilakquisition zur Ursprungsposition zurückkehrt, richtig erkannt werden.

Eine weitere Ausführungsform der vorliegenden Erfindung sieht vor, dass die Korrektur einer Teilakquisitionspartition während oder nach der Berechnung der für die Ausführung der entsprechenden Teilakquisitionspartition notwendigen Daten wie zeitliche Verläufe von Gradienten, HF-Pulse, ADC-Einstellungen, Frequenz- und Phasenverschiebungen, mittels eines Softwareinterfaces vorgenommen wird, wobei für die Berechnung dies unter Einbezug aktueller Positionsdaten erfolgt. Diese Variante ist besonders vorteilhaft, weil zur Implementierung der Korrektur keine erheblichen Hardwaremodifikationen notwendig sind.

Eine weitere Ausführungsform ist dadurch gekennzeichnet, dass die Korrektur einer Teilakquisitionspartition mittels eines Hardwareinterfaces vorgenommen wird. Zu den Vorteilen dieser Ausführungsform zählen sowohl die Möglichkeit die Korrekturen mit lediglich kleiner Verzögerung mit besonders kurzen Teilakquisitionspartitionen zu realisieren, als auch eine gewisse Unabhängigkeit von der MR-Scannerarchitektur und den Einzelheiten der laufenden MR-Aufnahme zu erhalten.

Besonders bevorzugt ist eine Variante des obigen Verfahrens, bei der das Hardwareinterface die digitalen Daten einer Teilakquisitionspartition nach deren Berechnung aber vor deren Umwandlung in analoge Signale korrigiert. Dabei erfolgt nach der Berechnung aller für die Ausführung der jeweiligen Teilakquisitionspartition benötigten Daten eine Modifikation dieser digitalen Daten entsprechend aktueller Positionsdaten. Der Vorteil dieser Ausführungsform ist eine geringe Komplexität des Hardwareinterfaces und der durchzuführenden Datenmodifikation.

Eine weitere Ausführungsform ist dadurch gekennzeichnet, dass das Hardwareinterface die analogen Steuersignale einer Teilakquisitionspartition während deren Ausspielen korrigiert. Dabei wird die Korrektur einzelner Teilakquisitionspartitionen mittels eines analogen Hardwareinterfaces vorgenommen, wobei nach der Digital-Analog-Wandlung der Daten einer Teilakquisition oder Teilakquisitionspartition eine Modifikation der analogen Signale entsprechend aktueller Positionsdaten erfolgt. Zu den Vorteilen dieser Ausführungsform zählen die Möglichkeiten noch schnellerer Korrekturen mit noch kürzeren Teilakquisitionspartitionen und einer größeren Unabhängigkeit von der MR-Scannerarchitektur und der laufenden Sequenz. Die genannten Vorteile ergeben sich allerdings zu Lasten einer erhöhten Komplexität des Hardwareinterfaces.

In einer weiteren bevorzugten Verfahrensvariante, wird ein Messsystem zur Erfassung der Objektposition verwendet, welches mindestens eine Kamera umfasst, welche die Objektposition direkt oder mit Hilfe zusätzlicher Marker, insbesondere einem oder mehreren RGR (=Retro Grade Reflector)-Markern bestimmt. Zur Unterstützung der Positionsbestimmung können ein oder mehrere Marker am zu untersuchenden Objekt befestigt werden. Diese Marker können sowohl passiver als auch aktiver Natur sein. Besonders vorteilhaft sind passive Marker mit RGR-Technologie (= Retro Grate Reflector), da diese eine sehr hohe Messgenauigkeit erlauben. Die Kamera oder Kameras können sich außer- oder innerhalb des Tomographen befinden.

In beiden Fällen müssen entsprechende Vorkehrungen zur MR-Kompatibilität, insbesondere zur Hochfrequenzabschirmung (HF-Abschirmung), getroffen werden. Ein besonderer Vorteil von dieser Variante ist, dass die Positionserfassung parallel zur MR-Aufnahme laufen kann und daher weitgehend unabhängig sowohl vom Scanner als auch von der Art der laufenden Aufnahme bleibt. Durch die Verwendung von Markern kann die Positionserfassung genauer und schneller gemacht werden.

Eine weitere bevorzugte Variante der Erfindung ist dadurch gekennzeichnet, dass mindestens ein Lichtwellenleiter zur Messung der Objektposition verwendet wird. Ein Ende jedes Lichtwellenleiters wird an einem ortsfesten Punk fixiert, das andere Ende wird am Messobjekt angebracht. Durch die bei Objektbewegung auftretende Verformung des Lichtwellenleiters oder der Lichtwellenleiter wird die Objektposition bestimmt. Im Vergleich zu Kameras sind Lichtwellenleiter vorteilhaft, weil sie keine direkte Sicht auf das Messobjekt bzw. den oder die verwendeten Marker erfordern.

Eine weitere bevorzugte Variante der Erfindung ist dadurch gekennzeichnet, dass mindestens eine MR-Navigatorsequenz ausgespielt wird und MR-Navigatorsignale zur Messung der Objektposition verwendet werden. Dazu wird im Sequenzverlauf eine kurze Signalausleseperiode eingefügt, welche durch zusätzliche Gradientenpulse unterstützt wird. Für diese Variante ist eine Unterbrechung des Signalverlaufs der MR-Aufnahme notwendig. Einerseits sind MR-Navigatorsequenzen nur für bestimmte Aufnahmen einsetzbar und ermöglichen nur wenige Korrekturen pro Sekunde. Andererseits ist diese Verwendungsvariante vorteilhaft, weil sie keine zusätzliche Messapparatur für Objektpositionserfassung benötigt. Von Vorteil ist auch, dass die Positionserfassung in MR-Koordinaten stattfindet.

Eine weitere bevorzugte Variante der Erfindung ist dadurch gekennzeichnet, dass die Sensitivität der HF-Spulen zur Bestimmung der Objektposition verwendet wird. Dabei werden aus der Signalstärke in einzelnen HF-Spulen Rückschlüsse auf die aktuelle Objektposition gezogen. Dies ist nur unter Verwendung von Arrayspulen möglich und weist nur limitierte Genauigkeit auf, hat aber den Vorteil schneller als MR-Navigatoren zu sein. Ähnlich wie für MR-Navigatoren ist auch hier keine zusätzliche Messapparatur zur Objektpositionserfassung nötig.

Eine weitere bevorzugte Variante der Erfindung ist dadurch gekennzeichnet, dass mindestens ein Magnetfeldsensor zur Messung der Objektposition verwendet wird. Jeder dieser Magnetfeldsensoren misst das Magnetfeld an der jeweiligen Sensorposition. Information über die zur Zeit der Messung ausgespielten Gradienten wird mit diesen Messdaten kombiniert und ermöglicht die Positionsbestimmung jedes Sensors. Vorteilhaft ist hierbei, dass nur wenige Hardwarekomponenten benötigt werden, und dass die Positionserfassung schneller als bei MR-Navigatoren ist und zudem in MR-Koordinaten stattfindet. Eine weitere bevorzugte Variante der Erfindung ist dadurch gekennzeichnet, dass vom MR-Tomographen zusätzliche Signale, insbesondere Gradientenpulse, HF-Pulse und Synchronisationssignale zur Unterstützung der Messung der Objektposition ausgespielt werden. Es ist zu beachten, dass die Objektposition vorzugsweise während des gesamten MR-Scans erfasst werden sollte. Dies kann in einem vom Messverfahren oder Messsystem vorgegebenen Zeitraster (vorzugsweise quasi-kontinuierlich) oder von Sequenzseite durch zusätzliche Signale, insbesondere Gradientenpulse, HF-Pulse und Synchronisationssignale getriggert, erfolgen. Der Vorteil dieser Variante ergibt sich durch eine zeitliche Synchronisierung und synergetische Funktion zwischen Scanner und Positionsmesssystem, womit eine bessere Korrekturqualität erzielt werden kann. Beispielsweise kann die Positionsbestimmung mittels Magnetfeldsensoren durch zusätzlich ausgespielte Gradienten unterstützt werden. Diese erfordern jedoch eine Unterbrechung im Signalverlauf der MR-Aufnahme.

Eine weitere bevorzugte Variante der Erfindung ist dadurch gekennzeichnet, dass die Positionsdaten des darzustellenden Objektes in sechs Freiheitsgraden gemessen werden, insbesondere drei Translationen und drei Rotationen. Die Positionsmessung kann sich dabei aus einer oder mehreren Einzelmessungen zusammensetzen und von einem oder mehreren Sensoren vorgenommen werden. Vorteilhaft dabei ist, dass dadurch alle möglichen Bewegungen von einem Festkörper im dreidimensionalen Raum beschrieben und korrigiert werden können.

Eine weitere bevorzugte Variante der Erfindung ist dadurch gekennzeichnet, dass die Positionsdaten des darzustellenden Objektes in weniger als sechs Freiheitsgraden gemessen werden, solange die für die Korrektur der nächsten Teilakquisitionspartition notwendigen Freiheitsgrade vorhanden sind. Die Relevanz eines bestimmten Freiheitsgrads für die aktuelle Teilakquisitionspartition wird dadurch bestimmt, ob die möglichen Veränderungen entlang dieses Freiheitsgrads eine Auswirkung auf die aktuelle Teilakquisitionspartition haben können. Die Positionsmessung kann sich dabei aus einer oder mehreren Einzelmessungen zusammensetzen und von einem oder mehreren Sensoren vorgenommen werden. Diese Ausführungsform hat von Vorteil, dass für bestimmte MR-Aufnahmen die Positionserfassung und -korrektur deutlich vereinfacht werden können.

Eine bevorzugte Verwendungsvariante ist dadurch gekennzeichnet, dass die verwendete MR-Aufnahme eine der bekannten für Bewegungsartefakte anfälligen Aufnahmemethoden ist, insbesondere DWI, RARE, Hyperecho-RARE, TRAPS-RARE, FLAIR und Gradientenecho mit Flusskodierung. Besonders vorteilhaft ist die Anwendung der erfindungsgemäßen Korrekturen in Verbindung mit etablierten und weit verbreiteten MR-Aufnahmen mit erhöhter Anfälligkeit zu durch Objektbewegung induzierten Signalstörungen und Artefakten, wie diffusionsgewichteter Bildgebung (DWI, DTI), T2-gewichteter Echozug-basierter Bildgebung (RARE, TSE, FSE, TRAPS, Hyperecho, FLAIR) oder Gradientenecho mit Flusskodierung.

Eine andere bevorzugte Verwendungsvariante ist dadurch gekennzeichnet, dass die verwendeten MR-Ausleseverfahren eines der bekannten für Bewegungsartefakte anfälligen Ausleseverfahren ist, insbesondere EPI, Spirale, Rosette, HASTE, RARE und bSSFP. Es wird vorgesehen, dass nach der Signalgenerierungsphase eine der etablierten Signalauslesemethoden angewendet werden, wobei die quasi-kontinuierlichen Korrekturen gemäß der vorliegenden Erfindung sowohl während der Signalgenerierung als auch während der Signalauslese angewendet werden können. Dies ist besonders vorteilhaft, da die erfindungsgemäßen Korrekturen mit traditionellen Methoden zur Signalauslese kombiniert werden können. Besonders bevorzugt sind die schnellen Auslesemethoden wie EPI (=Echo Planar Imaging), Spiraltrajektorie, Rosette-Trajektorie, HASTE (=Half fourier-Acquired Single shot Turbo spin Echo) und bSSFP (=Balanced Steady-State Free Precession).

Es ist zu beachten, dass je nach Auslesemethode das erfindungsgemäße, zeitliche Partitionierungsschema dem MR-Sequenzablauf angepasst werden muss. So ist es für die EPI-Auslese besonders vorteilhaft, die Positions- und Gradientenmoment-Korrektur einmal pro ein oder zwei Signalecho(s) anzuwenden. Die notwendigen Anpassungen der HASTE-Methode hingegen ähneln eher den näher beschriebenen Modifikationen der allgemeinen RARE-Sequenz.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- **Fig. 1**: ein Schema des erfindungsgemäßen Verfahrens zur dynamischen Bewegungskorrektur während einer Teilakquisition;
- **Fig.2**: ein Schema einer Variante des erfindungsgemäßen Verfahrens, wobei Korrekturabweichungen in vorherigen Teilakquisitionspartitionen während der laufenden Teilakquisition bzw. Teilakquisitionspartition korrigiert werden;
- **Fig.3**: ein Schema einer Variante eines Aufbaus des erfindungsgemäßen Verfahrens, wobei die Korrektur einer Teilakquisitionspartition mittels eines Softwareinterfaces vorgenommen wird;
- **Fig.4**: ein Schema einer Variante eines Aufbaus des erfindungsgemäßen Verfahrens, wobei die Korrektur der digitalen Signale einer Teilakquisitionspartition nach deren Berechnung aber vor deren Umwandlung in analoge Signale mittels eines Hardwareinterfaces vorgenommen wird;
- **Fig.5**: ein Schema eines Aufbaus einer Variante des erfindungsgemäßen Verfahrens, wobei ein Hardwareinterface die analogen Steuersignale einer Teilakquisitionspartition während deren Ausspielen korrigiert;
- **Fig. 6**: ein Schema einer Teilakquisition einer Echozug-basierten MR-Aufnahme (RARE), die mit Hilfe der erfindungsgemäßen Methode korrigiert wird;
- **Fig. 7**: ein Schema einer Teilakquisition einer Echo-Planar-Signalerfassung (EPI), bei der eine Bewegungskorrektur während der Ausleseperiode erfolgt; und
- **Fig.8**: Bilder zweier MR-Aufnahmen (DWI) während starker Kopfbewegung.

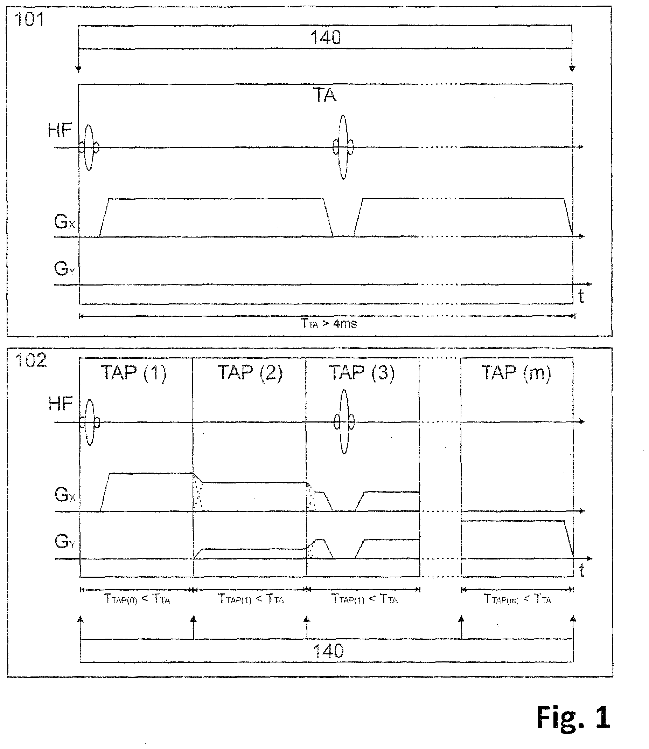

**Fig. 1** zeigt ein Schema des Verfahrens zur dynamischen Bewegungskorrektur während einer Teilakquisition TA, wobei eine Aufteilung der entsprechende Teilakquisition in kürzere Teilakquisitionspartitionen TAP(1), TAP(2), TAP(3), ..., TAP(m) erfolgt, wobei lange Gradienten in kürzere Teilgradienten aufgeteilt werden 102. Zum Vergleich wird die entsprechende Teilakquisition ohne die Anwendung des dargestellten Verfahrens gezeigt 101.

Dabei wird ein Teilgradient genau dann abgeschaltet, wenn der darauffolgende beginnt. Durch die Anstiegs- bzw. Abklingphasen eines Gradienten entsteht ein unterbrechungsfreier Übergang. Die Bewegungskorrektur erfolgt anhand der vom Messsystem **140** ermittelten Positionsdaten.

Bei der dargestellten Teilakquisition handelt es sich um den Abschnitt einer MR-Aufnahme zur DWI. DWI wird im klinischen Alltag häufig genutzt, um mikroskopische Bewegungsvorgänge im Gewebe darstellen zu können, welche ein sensitiver Marker für viele pathologische Erscheinungen sind. Dazu werden während der Signalkodierung sogenannte Diffusionsgradienten genutzt. Teilchenbewegung, die während der für eine Diffusionsgewichtung notwendigen Diffusionsgradienten auftritt, führt dazu, dass am Ende der Signalkodierung in von Bewegung betroffenen Voxeln die Spins nicht vollständig refokussiert werden und das spätere Messsignal somit eine diffusionsabhängige Signalabschwächung erfährt. Die Sensitivierung für mikroskopische Bewegungen macht die DWI-Sequenz allerdings auch gleichzeitig sehr anfällig für makroskopische Bewegungen. Erschwerend kommt hinzu, dass die resultierenden Phaseneffekte der makroskopischen Bewegungen deutlich die der mikroskopischen dominieren.

Des Weiteren liegt der typische Zeitbedarf für eine diffusionsgewichtete Signalkodierung im Bereich von 30-400ms. Bisher gängige Verfahren korrigierten Bewegung nur einmal zum Anfang und zum Ende dieses langen Zeitintervalls für Signalkodierung.

Objektbewegung, die während der Diffusionsgradienten und zwischen Schichtanregung und den typischerweise genutzten Refokussierungspulsen auftritt, war mit bekannten Methoden nicht korrigierbar. Das vorgestellte Verfahren ermöglicht aufgrund seiner quasi-kontinuierlichen Bewegungskorrektur eine unterbrechungsfreie Anpassung der Diffusionsgradienten und der verwendeten HF-Pulse an die Objektbewegung.

In **Fig.1** ist dargestellt, wie Gradienten während einer Teilakquisition ohne Unterbrechungen im Signalverlauf an auftretende Bewegung angepasste werden. Die zur Refokussierung genutzten HF-Pulse werden ebenfalls während der entsprechenden Teilakquisition unterbrechungsfrei an die aktuelle Objektposition angepasst.

In einer Weiterbildung dieses Ansatzes werden Bewegungs- und Korrekturverlauf während einer Teilakquisition analysiert. Bei Überschreitung von Bewegungsamplituden- bzw. Geschwindigkeitslimits kann eine oder mehrere Teilakquisitionen verworfen und wiederholt werden.

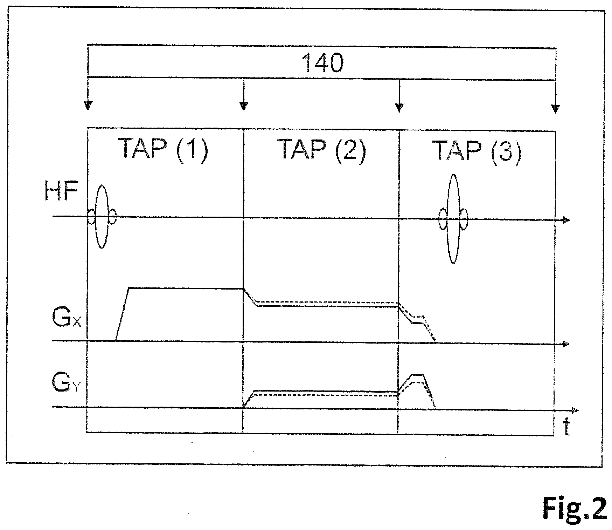

**Fig. 2** zeigt ein Schema einer Variante des Verfahrens entsprechend **Fig.1****,** bei der Korrekturabweichungen in vorherigen Teilakquisitionspartitionen während der laufenden Teilakquisition bzw. Teilakquisitionspartition durch Analyse der Bewegungsverlaufs detektiert und mittels zusätzlicher Gradientenmomente bzw. Phasenänderungen vor dem nächsten HF-Puls korrigiert werden.

Bei Berechnung der Korrekturparameter jeder Teilakquisitionspartition wird die bestmögliche Annahme über die Objektposition zur Bewegungskorrektur verwendet. Sollte im weiteren Verlauf der Teilakquisition eine bessere Annahme zur Objektposition zu Beginn oder Information über Bewegung während der entsprechenden Teilakquisitionspartition vorliegen, kann die Differenz zwischen zur Korrektur verwendeter und tatsächlicher Position und der daraus resultierende Phasenfehler berechnet und mit zusätzlichen Gradientenmomenten korrigiert werden. In der dargestellten Variante des erfindungsgemäßen Verfahrens werden diese zusätzlichen Gradientenmomente den bereits vorhandenen Gradienten überlagert.

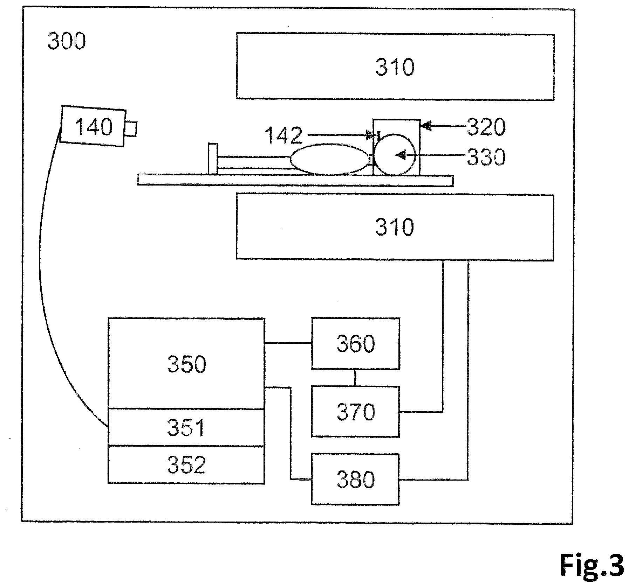

**Fig. 3** zeigt eine Variante des Aufbaus des erfindungsgemäßen Verfahrens zur prospektiven Bewegungskorrektur. Der Aufbau **300** beinhaltet einen Tomographen **310** mit Empfangsspule **320** und einem darzustellenden Messobjekt **330.** Des Weiteren beinhaltet der Aufbau ein Messsystem **140** zu Erfassung der Patientenposition. Des Weiteren beinhaltet der Aufbau **300** ein Echtzeitmodul **350** mit einem Rechenmodul **351** und einem Softwareinterface **352.** Des weiteren einen Signalgeneratormodul **360,** eine Verstärkereinheit **370** und ein Empfangsmodul **380.**

In einer Variante des erfindungsgemäßen Verfahrens konvertiert das Rechenmodul **351** die Positionsdaten des Messsystems **140** in das Bezugssystem des Kernspintomographen **310** und berechnet sämtliche Sequenzparameter aus dem Sequenzquellcode unter Einbezug des Softwareinterface **352.**

Das Softwareinterface **352** nutzt die verarbeiten Positionsdaten zur Bewegungskorrektur sämtlicher Sequenzparameter während deren Berechnung auf dem Rechenmodul **351.**

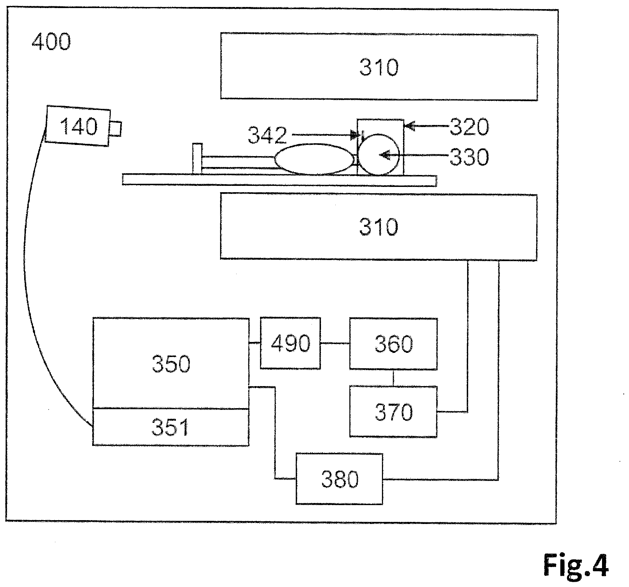

**Fig. 4** zeigt eine weitere Variante des Aufbaus des erfindungsgemäßen Verfahrens zur prospektiven Bewegungskorrektur. Der Aufbau **400** beinhaltet einen Tomographen **310** mit Empfangsspule **320** und einem darzustellenden Messobjekt **330.** Des Weiteren beinhaltet der Aufbau ein Messsystem **140** zu Erfassung der Patientenposition. Des Weiteren beinhaltet der Aufbau **300** ein Echtzeitmodul **350** mit einem Rechenmodul **351.** Des Weiteren ein Signalgeneratormodul **360**, eine Verstärkereinheit **370** und ein Empfangsmodul **380.** Dem Signalgeneratormodul ist ein Hardwareinterface **490** vorgeschaltet. In einer Variante des erfindungsgemäßen Verfahrens konvertiert das Rechenmodul **351** die Positionsdaten des Messsystems **140** in das Bezugssystem des Kernspintomographen **310** und berechnet sämtliche Sequenzparameter aus dem Sequenzquellcode.

Das Hardwareinterface **490** nutzt die verarbeiteten Positionsdaten zur Bewegungskorrektur durch Modifikation der digitalen Signale des Echtzeitmoduls **350** an den Signalgeneratormodul **360.**

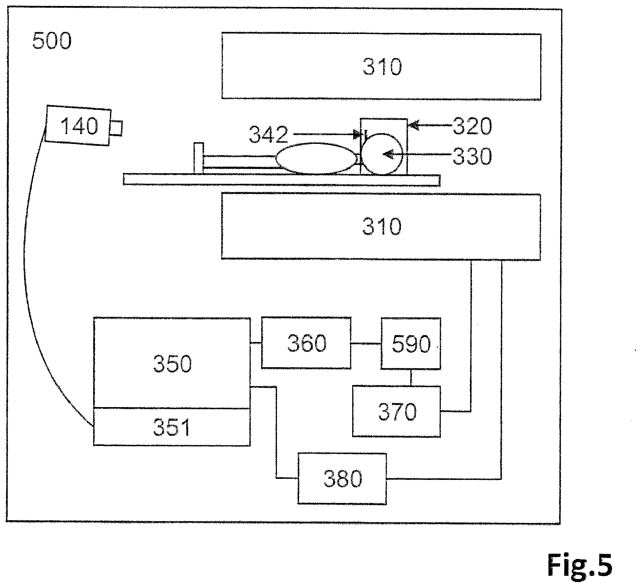

**Fig. 5** zeigt eine weitere Variante des Aufbaus des erfindungsgemäßen Verfahrens zur prospektiven Bewegungskorrektur. Der Aufbau **500** beinhaltet einen Tomographen **310** mit Empfangsspule **320** und einem darzustellenden Messobjekt **330.** Des Weiteren beinhaltet der Aufbau ein Messsystem **140** zu Erfassung der Patientenposition. Des Weiteren beinhaltet der Aufbau **500** ein Echtzeitmodul **350** mit einem Rechenmodul **351.** Des Weiteren ein Signalgeneratormodul **360,** eine Verstärkereinheit **370** und ein Empfangsmodul **380.** Der Verstärkereinheit **370** ist ein Hardwareinterface **590** vorgeschaltet. In einer Variante des erfindungsgemäßen Verfahrens konvertiert das Rechenmodul **351** die Positionsdaten des Messsystems **140** in das Bezugssystem des Kernspintomographen **310** und berechnet sämtliche Sequenzparameter aus dem Sequenzquellcode.

Das Hardwareinterface **590** nutzt die verarbeiteten Positionsdaten zur Bewegungskorrektur durch Modifikation der analogen Signale des Echtzeitmoduls **350** an den Signalgeneratormodul **360.**

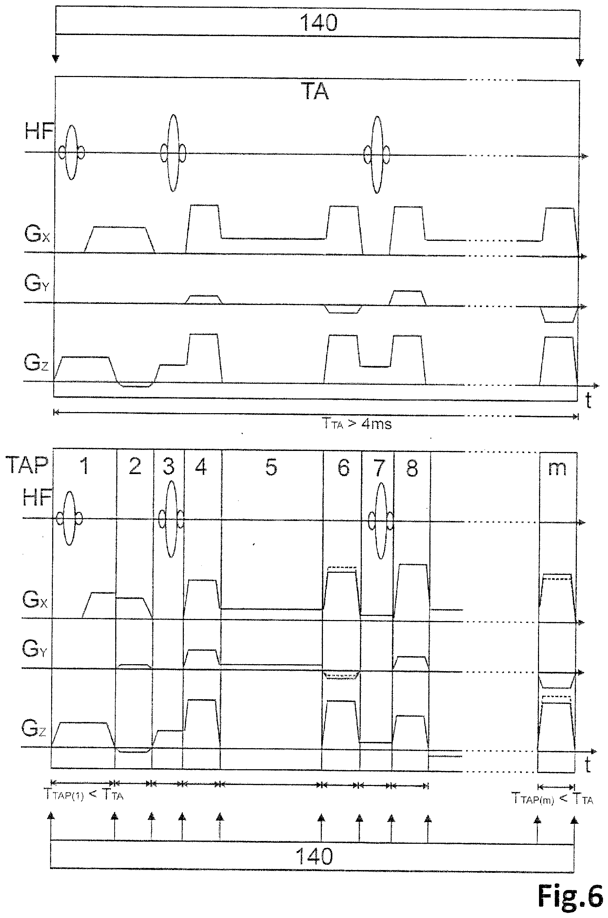

**Fig. 6** zeigt ein weiteres Schema einer Teilakquisition einer MR-Aufnahme, die mit Hilfe der vorgestellten Methode korrigiert wurde. Bei der gezeigten Teilakquisition handelt es sich um einen Teil einer RARE-Sequenz. Die RARE (Rapid Acquisition with Relaxation Enhancement)-Sequenz, auch bekannt als TSE- oder FSE (Turbo oder Fast Spin Echo)-Sequenz, ist eine weit verbreitete Bildgebungssequenz und ein sehr häufiges Auslesemodul in der MR. Obwohl ihr Signalverhalten zumeist als robust bezeichnet wird, besitzt die RARE-Sequenz doch eine merkliche Anfälligkeit für Artefakte aufgrund von Bewegungen während ihrer längeren Aufnahmezeit - im Bereich von etwa 1 Sekunde bis zu vielen Minuten - und ihrer Anwendung von zahlreichen, teils kombinierten Gradienten und HF-Pulsen.

Eine RARE-Sequenz wird entweder als sogenannte Single-Shot-Variante in Form von HASTE o.ä. betrieben, oder als sogenannte Multi-Shot-Variante, welche auch ursprünglich als hybrid RARE bekannt ist. Erstere besitzt lediglich einen Anregungspuls mit einer großen Zahl folgender Refokussierungspulse, während letztere den Ablauf von Anregungspulse zu Refokussierungspulsen in Repetitionsintervallen der Dauer TR (Repetitionszeit) wiederholt, welche typischerweise im Bereich von etwa 0,5 Sekunden bis vielen Sekunden liegt. Bisher gängige Verfahren korrigierten Bewegung bei der RARE-Sequenz nur einmal zum Anfang oder Ende des RARE-Echozuges, typischerweise vor der Schichtanregung.

Die einmalige Bewegungskorrektur pro Repetitionsintervall ist bei RARE basierten MR-Sequenzen nicht nur aufgrund des langen Repetitionsintervalls nachteilig, sondern auch äußerst problematisch aufgrund der essentiellen Phasenstabilität einer RARE-Sequenz, welche weithin als CPMG (Carr-Purcell-Meiboom-Gill) - Bedingungen bekannt sind. Jegliche Bewegung innerhalb eines Repetitionsintervalls führt zu empfindlichen Störungen der Phasenstabilität und damit schnell zu Bildartefakten in einer RARE-basierten MR-Sequenz.

Das vorgestellte Verfahren ermöglicht aufgrund seiner quasi-kontinuierlichen Bewegungskorrektur die Gewährleistung dieser CPMG-Bedingungen auch unter Objektbewegungen und ist somit eine Voraussetzung zur Betreibung einer RARE-Sequenz mit Bewegungskorrektur. Im besonderen Detail sind folgende drei Aspekte vonnöten:
1.) Zur Gewährleistung der CPMG-Bedingungen (Phasenstabilität) muss eine RARE basierte Sequenz das folgende Timing einhalten: Das erste Refokussierungsintervall - Mitte Anregungspuls bis Mitte erster Refokussierungspuls - muss halb so lang wie die folgenden Refokussierungsintervalle - Mitte Refokussierungspuls Nummer N bis zur Mitte des nächsten Refokussierungspulses Nummer N+1 - sein. Das vorgestellte Verfahren ermöglicht dies, weil es keine Zeit innerhalb des Timings beansprucht.
2.) Es ist essentiell, dass die Gradientenfläche - auch als nulltes Moment bezeichnet - pro Kodierungsachse (Gx, Gy und Gz) pro Refokussierungsintervall konstant ist, und im ersten Refokussierungsintervall exakt halb so groß wie in den folgenden ist. Das vorgestellte Verfahren ermöglicht dies, indem es bei Bewegungen die Gradienten quasi-kontinuierlich korrigiert und so direkt im eigentlichen, gemessenen Objekt diese notwendige Phasenstabilität erreicht und gewährleistet. Unter "Gradienten" werden hierbei alle verschiedenen, in einer RARE benutzten Funktionstypen von Gradienten wie Lesekodierung, Phasenkodierung, Schichtselektion, Crusher, Spoiler usw. verstanden. Insbesondere macht das vorgestellte Verfahren optional davon Gebrauch, dass es vor Ende jedes Refokussierungsintervalls zusätzliche Gradientenmomente bzw. Phasenänderungen anwendet. Diese Gradientenmomente zur Abweichungskorrektur können bereits vorhandenen Gradienten überlagert werden was keine Zeit innerhalb des Timings beansprucht.
3.) Weiterhin essentiell ist, dass die ursprünglich gesetzten Phasenbeziehungen der HF-Pulse - die sog. anfänglichen Phasen - erhalten bleiben. Das vorgestellte Verfahren ermöglicht dies, indem es ebenfalls die Trägerfrequenzen und Phasen der HF-Pulse gemäß der Bewegungskorrektur anpasst, so dass im gemessenen Objekt die vorgesehenen, anfänglichen Phasen der HF-Pulse erhalten bleiben.

Die Allgemeinheit des vorgeschlagenen Prinzips ermöglicht sowohl die Bewegungskorrektur bei konventionellen RARE-Typen (RARE, TSE, FSE, HASTE u.ä.) mit konstanten Flipwinkeln und konstanten anfänglichen Phasen für die Refokussierungspulse, als auch die moderneren Varianten mit variablen Flipwinkeln und konstanten anfänglichen Phasen für die Refokussierungspulse (TRAPS, hyperTSE, SPACE, CUBE, VISTA u.ä.) oder variablen Flipwinkeln und alternierenden anfänglichen Phasen (verallgemeinerte CPMG-Bedingungen). Der Anregungspuls ist bei allen Typen jeweils beliebig vom Flipwinkel bei gleicher oder um 90° verschobener Phase zum ersten Refokussierungspuls.

Des Weiteren sind durch die Allgemeinheit des Ansatzes auch RARE-ähnliche Sequenzen möglich und eingeschlossen, die noch die CPMG-Bedingungen für die Gradienten erfüllen, aber sowohl die anfänglichen Phasen als auch die Flipwinkel für Refokussierungspulse und Anregungspuls variabel halten, wie beispielsweise RARE-Sequenzen, die dem Hyperecho-Prinzip folgen.

Nur ein Verfahren, das die in der Summe vorgestellten Bewegungskorrekturen vornimmt, erreicht artefaktfreie Bilder in einer RARE basierten Bildgebungssequenz oder einem RARE-basierten Auslesemodul.

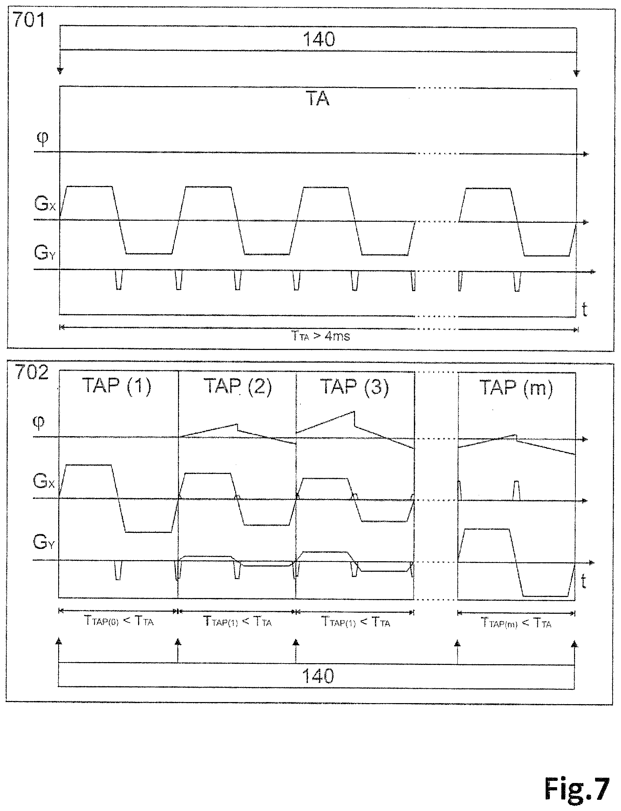

**Fig.7** zeigt ein Schema einer Variante, wobei Information über die Objektposition während des Auslesevorgangs genutzt wird um eine Bewegungskorrektur zu realisieren. Zum Vergleich wird die entsprechende Teilakquisition ohne die Anwendung des dargestellten Verfahrens gezeigt. Das gezeigte Ausleseverfahren zeigt die häufig eingesetzte Echo-Planar Bildgebung (EPI). Die EPI erlaubt das Auslesen eines gesamten MR-Datensatzes nach nur einer Signalkodierung und gilt daher als besonders resistent gegen Bewegungsartefakte. Die Dauer solch eines Auslesevorgangs nimmt allerdings typischerweise 50-100ms in Anspruch und Bewegung, die in diesem Zeitraum auftritt, führt zu Bildartefakten. Bisher gängige Verfahren erlauben nur eine einmalige Bewegungskorrektur zu Beginn der EPI, Bewegung die während des Auslesevorgangs auftritt kann mit diesen Verfahren nicht korrigiert werden. Des Weiteren profitieren auch andere Ausleseverfahren mit langer Dauer (> 4ms) (z.B. Spirale, Rosette, etc.) von dieser Variante.

Besonders bevorzugt ist eine Variante des Verfahrens, bei welcher die Objektposition in 6 Freiheitsgraden (insbesondere 3 Translationen und 3 Rotationen) bestimmt wird, weil dies eine vollständige Beschreibung eines Festkörpers erlaubt.

In einer weiteren Variante des Verfahrens kann auch eine Objektposition in weniger als 6 Freiheitsgraden für eine Bewegungskorrektur verwendet werden. Dies ist dann möglich, wenn innerhalb einer Teilakquisitionspartition alle für mögliche Bewegungsartefakte verantwortliche Freiheitsgrade bekannt sind. Beispielhaft sei die Bewegungskorrektur von **TAP(2)** in **Fig.1** angeführt. Für die anzuwendende Bewegungskorrektur ist in diesem Fall die Bestimmung der Objektposition in 2 Freiheitsgraden ausreichend (2 Rotationen um die Achsen orthogonal zur Gradientenrichtung).

In einer Variante des Verfahrens wird bei der Bestimmung der Objektposition auch Information über den bisherigen Bewegungsverlauf einbezogen. Mit Hilfe kinematischer Modelle (z.B. Kaiman Filter) kann die Bewegungskorrektur entsprechend angepasst werden. Mit dieser Methode lassen sich beispielsweise Fehler durch Verzögerungen im Signalverlauf oder Ungenauigkeiten durch Signalrauschen reduzieren. Auch kann bei Detektion von Bewegungsmustern, die nicht denen eines festen Körpers entsprechen, eine bestmögliche Korrektur berechnet und angewandt werden.

Weitere Vorteile der Erfindung ergeben sich aus Kombinationen der in den **Figuren 1 bis 7** dargestellten Grundprinzipien. Die gezeigten und beschriebenen Ausführungsformen sind nicht als abschließende Aufzählung zu verstehen, sondern haben vielmehr beispielhaften Charakter für die Schilderung der Erfindung.

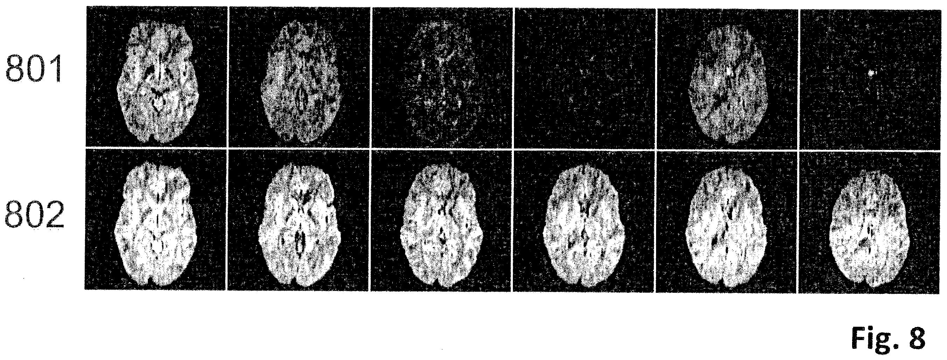

**Fig.8** zeigt Bilder zweier MR-Aufnahme (DWI), wobei **801** eine MR-Aufnahme zeigt bei der die Bewegungskorrektur einmalig vor Schichtanregung durchgeführt wurde und **802** eine MR-Aufnahme bei der die Bewegungskorrektur entsprechend des erfindungsgemäßen Verfahrens während der Diffusionswichtung angewendet wurde. Während beiden Aufnahmen trat vergleichbare starke Kopfbewegung auf. Während bei der ersten Aufnahme **801** Signalverluste zur erkennen sind, werden diese Signalverluste in der zweiten Aufnahme **802** verhindert. Der Vergleich der beiden Aufnahmen zeigt deutlich die Vorteile des erfindungsgemäßen Verfahrens.

### Referenzliste

[1] Bammer, R., *Apparatus and method for real-time motion-compensated magnetic resonance imaging.* 2007, US 2009/0209846 A1.
[2] Runge, V.M., et al., Respiratory gating in magnetic resonance imaging at 0.5 Tesla. Radiology, 1984. 151(2): p. 521-523.
[3] Odille, F., et al., Generalized Reconstruction by Inversion of Coupled Systems (GRICS) applied to free-breathing MRI. Magnetic Resonance in Medicine, 2008. 60(1): p. 146-157.
[4] White, N., et al., PROMO: Real-Time Prospective Motion Correction in MRI Using Image-Based Tracking. Magnetic Resonance in Medicine, 2010. 63(1): p. 91-105.
[5] Norris, D.G. and W. Driesel, Online motion correction for diffusion-weighted imaging using navigator echoes: Application to RARE imaging without sensitivity loss. Magnetic Resonance in Medicine, 2001. 45(5): p. 729-733.
[6] Zaitsev, M., et al., Magnetic resonance imaging of freely moving objects: Prospective real-time motion correction using an external optical motion tracking system. Neuroimage, 2006. 31(3): p. 1038-1050.
[7] Ernst, T.M., T.E. Prieto, and B.S.R. Armstrong, *Motion tracking system for real time adaptive imaging and spectroscopy.* 2007, WO 2007/136745 A2**.**
[8] Dold, C., *Reducing movement artifacts in magnetic resonance measurements.* 2004, US 7,295,007 B2**.**
[9] Aksoy, M., et al., Real-time optical motion correction for diffusion tensor imaging. Magnetic Resonance in Medicine: early review online, DOI 10.1002/mrm.22787.
[10] Andrews-Shigaki, B.C., et al., Prospective motion correction for magnetic resonance spectroscopy using single camera retro-grate reflector optical tracking. Journal of Magnetic Resonance Imaging. 33(2): p. 498-504.
[11] J. L. Duerk, Principles of MR image formation and reconstruction, Magn Reson Imaging Clin N Am, vol. 7, pp. 629--659, Nov 1999.

## Patentansprüche

1. Verfahren der MR-Bildgebung oder der ortsaufgelösten MR-Spektroskopie zur Reduzierung durch Bewegung eines darzustellenden Objekts auftretender Artefakte, wobei eine MR-Aufnahme des darzustellenden Objekts mit einem MR-Tomographen erfolgt, indem eine MR-Sequenz ausgeführt wird, in deren Repetitionszeit-Intervall ein oder mehrere HF-Pulse und mehrere Magnetfeldgradientenpulse eingestrahlt werden, wobei das Repetitionszeit-Intervall eine MR-Signalgewichtungsperiode und eine MR-Signalausleseperiode umfasst, wobei die aktuelle Position des darzustellenden Objekts während der Laufzeit der MR-Aufnahme quasi-kontinuierlich bestimmt wird, wobei eine prospektive Bewegungskorrektur während der Laufzeit der MR-Aufnahme vorgenommen wird, welche eine dynamische Anpassung der Frequenz- und Phaseneinstellungen des HF-Systems des MR-Tomographen und der Orientierung und der Amplituden der Gradientenpulse in der Art umfasst, dass das darzustellende Volumen an die aktuelle Position des darzustellenden Objekts angepasst wird,
wobei die Bewegungskorrektur ohne Unterbrechung oder Verlangsamung des zeitlichen Ablaufs der MR-Aufnahme erfolgt,
**dadurch gekennzeichnet,**
**dass** die MR-Signalgewichtungsperiode in mehrere Teilakquisitionspartitionen (TAP) aufgeteilt wird und Gradientenpulse der MR-Signalgewichtungsperiode in kürzere Teilgradienten derart aufgeteilt werden, dass jeder Teilgradient nur während einer einzigen Teilakquisitionspartition (TAP) eingeschaltet wird, und dass die prospektive Bewegungskorrektur für jede der Teilakquisitionspartitionen (TAP) der MR-Signalgewichtungsperiode erfolgt, wobei die dynamische Anpassung der Frequenz- und Phaseneinstellungen des HF-Systems des MR-Tomographen und der Orientierung und der Amplituden der Gradientenpulse für die jeweilige Teilakquisitionspartition (TAP) unter Einbezug der aktuellen Position des darzustellenden Objekts erfolgt.

2. Verfahren nach Anspruch 1, **dadurch gekennzeichnet, dass** Korrekturabweichungen in vorherigen Teilakquisitionspartition (TAP) während der laufenden Teilakquisition (TA) oder Teilakquisitionspartition (TAP) detektiert und mittels zusätzlicher Gradientenmomente oder Phasenänderungen vor der Signalausleseperiode oder dem nächsten HF-Puls korrigiert werden.

3. Verfahren nach Anspruch 2, **dadurch gekennzeichnet, dass** die zusätzlichen Gradientenmomente zur Abweichungskorrektur bereits vorhandenen Gradienten überlagert werden.

4. Verfahren nach einem der vorhergehenden Ansprüche, **dadurch gekennzeichnet, dass** bei Überschreitung von Bewegungsamplituden- oder Geschwindigkeitslimits eine oder mehrere Teilakquisitionen (TA) verworfen und wiederholt werden.

5. Verfahren nach einem der vorhergehenden Ansprüche, **dadurch gekennzeichnet, dass** die Korrektur einer Teilakquisitionspartition (TAP) während oder nach der Berechnung der für die Ausführung der entsprechenden Teilakquisitionspartition (TAP) notwendigen Daten mittels eines Softwareinterfaces vorgenommen wird.

6. Verfahren nach einem der vorhergehenden Ansprüche, **dadurch gekennzeichnet, dass** die Korrektur einer Teilakquisitionspartition (TAP) mittels eines Hardwareinterfaces vorgenommen wird.

7. Verfahren nach Anspruch 6, **dadurch gekennzeichnet, dass** das Hardwareinterface die digitalen Daten einer Teilakquisitionspartition (TAP) nach deren Berechnung aber vor deren Umwandlung in analoge Signale korrigiert.

8. Verfahren nach Anspruch 6 oder 7, **dadurch gekennzeichnet, dass** das Hardwareinterface die analogen Steuersignale einer Teilakquisitionspartition (TAP) während deren Ausspielen korrigiert.

9. Verfahren nach einem der vorhergehenden Ansprüche, **dadurch gekennzeichnet, dass** ein Messsystem zur Erfassung der Objektposition verwendet wird, welches mindestens eine Kamera umfasst, welche die Objektposition direkt oder mit Hilfe zusätzlicher Marker, insbesondere einem oder mehreren RGR (=Retro Grade Reflector)-Markern bestimmt.

10. Verfahren nach einem der vorhergehenden Ansprüche, **dadurch gekennzeichnet, dass** mindestens ein Lichtwellenleiter zur Messung der Objektposition verwendet wird.

11. Verfahren nach einem der vorhergehenden Ansprüche, **dadurch gekennzeichnet, dass** mindestens eine MR-Navigatorsequenz ausgespielt wird und MR-Navigatorsignale zur Messung der Objektposition verwendet werden.

12. Verfahren nach einem der vorhergehenden Ansprüche, **dadurch gekennzeichnet, dass** die Sensitivität der HF-Spulen zur Bestimmung der Objektposition verwendet wird.

13. Verfahren nach einem der vorhergehenden Ansprüche, **dadurch gekennzeichnet, dass** mindestens ein Magnetfeldsensor zur Messung der Objektposition verwendet wird.

14. Verfahren nach einem der vorgehenden Ansprüche, **dadurch gekennzeichnet, dass** vom Kernspintomographen zusätzliche Signale, insbesondere Gradientenpulse, HF-Pulse und Synchronisationssignale zur Unterstützung der Messung der Objektposition ausgespielt werden.

15. Verfahren nach einem der Ansprüche 9 bis 13, **dadurch gekennzeichnet, dass** die Positionsdaten des darzustellenden Objektes in sechs Freiheitsgraden gemessen werden, insbesondere drei Translationen und drei Rotationen.

16. Verfahren nach einem der Ansprüche 9 bis 13, **dadurch gekennzeichnet, dass** die Positionsdaten des darzustellenden Objektes in weniger als sechs Freiheitsgraden gemessen werden, solange die für die Korrektur der nächsten Teilakquisitionspartition (TAP) notwendigen Freiheitsgrade vorhanden sind.

17. Verfahren nach einem der vorhergehenden Ansprüche, **dadurch gekennzeichnet, dass** für die MR-Aufnahme eine für Bewegungsartefakte empfindliche Aufnahmemethode verwendet wird, insbesondere DWI, RARE, Hyperecho-RARE, TRAPS-RARE, FLAIR und Gradientenecho mit Flusskodierung.

18. Verfahren nach einem der vorhergehenden Ansprüche, **dadurch gekennzeichnet, dass** als MR-Ausleseverfahren ein für Bewegungsartefakte empfindliches Ausleseverfahren verwendet wird, insbesondere EPI, Spirale, Rosette, HASTE, RARE und bSSFP.

## Claims

1. A method of MR imaging or spatially resolved MR spectroscopy for reducing artifacts occurring due to motion of an object to be represented, wherein MR acquisition of the object to be represented is performed using an MR tomograph by carrying out an MR sequence, in the repetition time interval of which one or more RF pulses and a plurality of magnetic field gradient pulses are irradiated, wherein the repetition time interval comprises an MR signal weighting period and an MR signal read-out period, wherein the current position of the object to be represented is quasi continuously determined during the duration of the MR acquisition, wherein prospective motion correction is performed during the duration of the MR acquisition, which comprises dynamic adjustment of the frequency and phase adjustments of the RF system of the MR tomograph and of the orientation and the amplitudes of the gradient pulses such that the volume to be represented is adjusted to the current position of the object to be represented,
wherein the motion correction is performed without interrupting or slowing the temporal progression of the MR acquisition.
**characterized in that**
the MR signal weighting period is divided into a plurality of partial acquisition partitions (TAP) and gradient pulses of the MR signal weighting period are divided into shorter partial gradients such that each partial gradient is only switched during a single partial acquisition partition (TAP), and that the prospective motion correction is performed for each of the partial acquisition partitions (TAP) of the MR signal weighting period, wherein the dynamic adjustment of the frequency and phase adjustments of the RF system of the MR tomograph and of the orientation and the amplitudes of the gradient pulses for each partial acquisition partition (TAP) is performed thereby including the current position of the object to be represented.

2. The method according to claim 1, **characterized in that** correction deviations in previous partial acquisition partitions (TAP) are detected during a current partial acquisition (TA) or partial acquisition partition (TAP) and are corrected using additional gradient moments or phase changes before the signal read-out period or before a next RF pulse.

3. The method according to claim 2, **characterized in that** the additional gradient moments for deviation correction are superposed on already existing gradients.

4. The method according to any one of the preceding claims, **characterized in that** when motion amplitude or velocity limits are exceeded, one or more partial acquisitions (TA) are rejected and are repeated.

5. The method according to any one of the preceding claims, **characterized in that** correction of a partial acquisition partition (TAP) during or after calculation of data required to perform a corresponding partial acquisition partition (TAP) is performed by means of a software interface.

6. The method according to any one of the preceding claims, **characterized in that** correction of a partial acquisition partition (TAP) is performed by means of a hardware interface.

7. The method according to claim 6, **characterized in that** the hardware interface corrects digital data of a partial acquisition partition (TAP) after calculation but before conversion to analog signals.

8. The method according to claim 6 or 7, **characterized in that** the hardware interface corrects analog control signals of a partial acquisition partition (TAP) while the signals are being run.

9. The method according to any one of the preceding claims, **characterized in that** a measurement system for sensing the object position is used, which comprises at least one camera, wherein the camera determines the object position directly or using additional markers, in particular one or more RGR (= retro grade reflector) markers.

10. The method according to any one of the preceding claims, **characterized in that** at least one light guide is used to measure the object position.

11. The method according to any one of the preceding claims, **characterized in that** at least one MR navigator sequence is run and MR navigator signals are used to measure the object position.

12. The method according to any one of the preceding claims, **characterized in that** the sensitivity of RF coils is used to determine the object position.

13. The method according to any one of the preceding claims, **characterized in that** at least one magnetic field sensor is used to measure the object position.

14. The method according to any one of the preceding claims, **characterized in that** the NMR tomograph generates additional signals, in particular gradient pulses, RF pulses and synchronization signals for supporting the measurement of the object position.

15. The method according to any one of the claims 9 to 13, **characterized in that** the position data of the object to be represented are measured in six degrees of freedom, in particular three translations and three rotations.

16. The method according to any one of the claims 9 to 13, **characterized in that** the position data of the object to be represented are measured in fewer than six degrees of freedom as long as the degrees of freedom required for correction of a next partial acquisition partition (TAP) are available.

17. The method according to any one of the preceding claims, **characterized in that** an acquisition method is used for MR acquisition that is a method sensitive to motion artifacts, in particular a DWI method, a RARE method, a hyperecho RARE method, a TRAPS-RARE method, a FLAIR method and a gradient echo method with flow encoding.

18. The method according to any one of the preceding claims, **characterized in that** an MR read-out method is used that is a read-out method sensitive to motion artifacts, in particular an EPI method, a spiral method, a rosette method, a HASTE method, a RARE method or a bSSFP method.

## Revendications

1. Procédé d'imagerie RM ou de spectroscopie RM à résolution spatiale pour réduire les artefacts se produisant en raison du mouvement d'un objet à représenter, dans lequel un enregistrement RM de l'objet à représenter est effectué avec un tomographe RM en exécutant une séquence RM dans l'intervalle de temps de répétition de laquelle une ou plusieurs impulsions HF et plusieurs impulsions de gradient de champ magnétique sont émises, dans lequel l'intervalle de temps de répétition comprend une période de pondération de signal RM et une période de lecture de signal RM, dans lequel la position actuelle de l'objet à représenter est déterminée de manière quasi continue pendant la durée de l'enregistrement RM, dans lequel une correction de mouvement prospective est effectuée pendant la durée de l'enregistrement RM, qui comprend une adaptation dynamique des réglages de fréquence et de phase du système HF du tomographe RM et de l'orientation et des amplitudes des impulsions de gradient de telle manière que le volume à représenter soit adapté à la position actuelle de l'objet à représenter,
dans lequel la correction de mouvement est effectuée sans interruption ou ralentissement du déroulement temporel de l'enregistrement RM,
**caractérisé en ce**
**que** la période de pondération de signal RM est divisée en une pluralité de partitions d'acquisition partielle (TAP) et les impulsions de gradient de la période de pondération de signal RM sont divisées en gradients partiels plus courts, de telle sorte que chaque gradient partiel est activé seulement pendant une seule partition d'acquisition partielle (TAP),
et **que** la correction de mouvement prospective est effectuée pour chacune des partitions d'acquisition partielle (TAP) de la période de pondération de signal RM, l'adaptation dynamique des paramètres de fréquence et de phase du système HF du tomographe RM et de l'orientation et des amplitudes des impulsions de gradient pour la partition d'acquisition partielle (TAP) respective étant effectuée en tenant compte de la position actuelle de l'objet à représenter.

2. Procédé selon la revendication 1, **caractérisé en ce que** des écarts de correction dans les partitions d'acquisition partielle (TAP) précédentes sont détectés pendant l'acquisition partielle (TA) ou la partition d'acquisition partielle (TAP) actuelle et corrigés au moyen de moments de gradient supplémentaires ou de changements de phase avant la période de lecture de signal ou la prochaine impulsion HF.

3. Procédé selon la revendication 2, **caractérisé en ce que** les moments de gradient supplémentaires pour la correction des écarts sont superposés aux gradients déjà existants.

4. Procédé selon l'une des revendications précédentes, **caractérisé en ce qu'**une ou plusieurs acquisitions partielles (TA) sont rejetées et répétées en cas de dépassement de limites d'amplitude de mouvement ou de vitesse.

5. Procédé selon l'une des revendications précédentes, **caractérisé en ce que** la correction d'une partition d'acquisition partielle (TAP) est effectuée pendant ou après le calcul des données nécessaires à l'exécution de la partition d'acquisition partielle (TAP) correspondante au moyen d'une interface logicielle.

6. Procédé selon l'une des revendications précédentes, **caractérisé en ce que** la correction d'une partition d'acquisition partielle (TAP) est effectuée au moyen d'une interface matérielle.

7. Procédé selon la revendication 6, **caractérisé en ce que** l'interface matérielle corrige les données numériques d'une partition d'acquisition partielle (TAP) après son calcul mais avant sa conversion en signaux analogiques.

8. Procédé selon la revendication 6 ou 7, **caractérisé en ce que** l'interface matérielle corrige les signaux de commande analogiques d'une partition d'acquisition partielle (TAP) pendant leur exécution.

9. Procédé selon l'une des revendications précédentes, **caractérisé en ce qu'**on utilise, pour détecter la position de l'objet, un système de mesure qui comprend au moins une caméra qui détermine la position de l'objet directement ou au moyen de marqueurs supplémentaires, en particulier d'un ou plusieurs marqueurs RGR (=Retro Grade Reflector).

10. Procédé selon l'une des revendications précédentes, **caractérisé en ce qu'**au moins un guide d'ondes optiques est utilisé pour mesurer la position de l'objet.

11. Procédé selon l'une des revendications précédentes, **caractérisé en ce qu'**au moins une séquence de navigateur RM est exécutée et des signaux de navigateur RM sont utilisés pour mesurer la position de l'objet.

12. Procédé selon l'une des revendications précédentes, **caractérisé en ce que** la sensibilité des bobines HF est utilisée pour déterminer la position de l'objet.

13. Procédé selon l'une des revendications précédentes, **caractérisé en ce qu'**au moins un capteur de champ magnétique est utilisé pour mesurer la position de l'objet.

14. Procédé selon l'une des revendications précédentes, **caractérisé en ce que** des signaux supplémentaires, en particulier des impulsions de gradient, des impulsions HF et des signaux de synchronisation sont émis par le tomographe à résonance magnétique pour assister la mesure de la position de l'objet.

15. Procédé selon l'une des revendications 9 à 13, **caractérisé en ce que** les données de position de l'objet à représenter sont mesurées selon six degrés de liberté, en particulier trois translations et trois rotations.

16. Procédé selon l'une des revendications 9 à 13, **caractérisé en ce que** les données de position de l'objet à représenter sont mesurées selon moins de six degrés de liberté tant que les degrés de liberté nécessaires à la correction de la partition d'acquisition partielle (TAP) suivante sont présents.

17. Procédé selon l'une des revendications précédentes, **caractérisé en ce qu'**on utilise pour l'enregistrement RM une méthode d'enregistrement sensible aux artefacts de mouvement, en particulier DVV1, RARE, Hyperecho-RARE, TRAPS-RARE, FLAIR et écho de gradient avec codage de flux.

18. Procédé selon l'une des revendications précédentes, **caractérisé en ce qu'**on utilise comme procédé de lecture RM un procédé de lecture sensible aux artefacts de mouvement, en particulier EPI, spirale, rosette, HASTE, RARE et bSSFP.
